# FASCICULE DE BREVET EUROPEEN

(11) **EP 0 883 698 B1**
(45) Date de publication et mention de la délivrance du brevet: **12.01.2000**
(21) Numéro de dépôt: 97907127.1
(22) Date de dépôt: 25.02.1997
(51) Int. Cl.: C23C 16/34, C23C 16/44

(54) **PROCEDE DE FORMATION DE REVETEMENTS DE Ti1-xAlxN**
VERFAHREN ZUR HERSTELLUNG VON Ti 1-xAlxN BESCHICHTUNGEN
METHOD FOR FORMING Ti 1-xAlxN COATINGS

(30) Priorité: 27.02.1996 FR 9602699
(43) Date de publication de la demande: 16.12.1998
(73) Titulaire: CENTRE NATIONAL DE LA RECHERCHE SCIENTIFIQUE (CNRS), 75700 Paris Cedex 07 (FR)
(72) Inventeur: MADAR, Roland, F-38320 Eybens (FR); ROUAULT, Alain, F-38320 Poisat (FR); BLANQUET, Elisabeth, F-38100 Grenoble (FR); BERNARD, Claude, F-38320 Brie et Angonnes (FR); DUTRON, Anne-Marie, F-38000 Grenoble (FR)
(74) Mandataire: de Beaumont, Michel
(86) Numéro de dépôt international: FR9700336
(87) Numéro de publication internationale: WO9732057

(56) Documents cités:
- WO-A-90/11858
- US-A- 4 138 512
- PROC. EUR. CONF. CHEM. VAP. DEPOSITION, 6TH (1987), 114-19. EDITOR(S): PORAT, REUVEN. PUBLISHER: ISCAR LTD., NAHARIYA, ISRAEL. CODEN: 56USAN, 1987, XP000609373 VAN DEN BERG, HENK ET AL: "A new CVD coating for hardmetal cutting tools"
- JOURNAL OF VACUUM SCIENCE AND TECHNOLOGY: PART A, vol. 12, no. 4, Juillet 1994 - Août 1994, NEW YORK US, pages 1602-1607, XP000608885 SANG-HEOB LEE ET AL.: "(Ti1-xAlx)N coatings by plasma enhanced chemical vapor deposition" cité dans la demande

## Description

La présente invention concerne la formation de revêtements de composés de type Ti_{1-X}AlₓN sur des substrats.

L'intérêt de tels revêtements est bien connu dans la technique. En effet, il est connu depuis longtemps qu'il est particulièrement intéressant de déposer des couches de TiN sur des pièces devant être durcies en surface, par exemple des outils de coupe, pour augmenter leur résistance à l'usure. Toutefois, on a constaté que les couches de TiN tendaient à se détériorer au cours du temps par oxydation. Par contre, l'insertion d'aluminium dans le réseau de TiN conduit à une bonne résistance à l'oxydation car il se forme en cours d'usage une couche mince d'Al₂O₃ qui protège le revêtement dur, ce qui permet d'augmenter considérablement le temps d'utilisation de l'outil. Ce résultat n'est pas obtenu par un dépôt mixte de TiN et d'AlN.

Ainsi, de nombreuses recherches ont porté sur la réalisation de dépôts de Ti₁₋ₓAlₓN. Les procédés connus sont essentiellement des dépôts physiques tels que des pulvérisations réactives, éventuellement assistés par un magnétron, et des dépôts réactifs par arc. Ces procédés sont délicats à mettre en oeuvre étant donné notamment les problèmes de réalisation de sources. En outre, des procédés de type pulvérisation ou projection sont mal adaptés au revêtement de pièces de formes complexes.

On a donc naturellement essayé de trouver un procédé de dépôt de type dépôt chimique en phase vapeur. Toutefois, alors que l'on sait déposer en phase vapeur des couches de TiN ou des couches d'AlN à partir de chlorure de titane et de chlorure d'aluminium en présence d'ammoniac et/ou d'azote, on a toujours considéré que l'utilisation simultanée de chlorure de titane et de chlorure d'aluminium conduirait à l'obtention de dépôts mixtes d'AlN et de TiN et non pas au dépôt d'une couche homogène d'une phase de type Ti₁₋ₓAlₓN.

En outre, des essais de revêtements par dépôt chimique en phase vapeur à partir de composés organo-métalliques de titane et d'aluminium se sont révélés jusqu'à présent infructueux.

On notera plus particulièrement l'article de Sang-Hyeob Lee, Ho-Joon Ryoo et Jung-Joog Lee de l'Université de Séoul, J. Vac. Sci. Technol., A 12(4), juil-août 1994. Dans l'introduction de cet article, les auteurs rappellent les divers procédés connus de formation de revêtements de Ti₁₋ₓAlₓN tels que mentionnés ci-dessus et exposent les difficultés qui se présentent du fait que TiN présente une structure de type NaCl tandis que AlN cristallise en structure hexagonale de type wurtzite. Néanmoins, les auteurs ont cherché à trouver un procédé par dépôt chimique en phase vapeur et prétendent arriver à l'obtention de revêtements de Ti₁₋ₓAlₓN par une technique de dépôt chimique en phase vapeur assistée par plasma en partant de TiCl₄, AlCl₃, NH₃, H₂ et d'argon (formant le plasma) dans un plasma RF de 15 à 200 watts. On soulignera qu'un dépôt chimique en phase vapeur assisté par plasma n'est pas une opération simple et ne se prête pas non plus au revêtement de pièces de formes complexes.

Un objet de la présente invention est de proposer un procédé de dépôt chimique en phase vapeur de couches de Ti₁₋ ₓAlₓN en partant de précurseurs simples et sans recourir à une assistance plasma.

Pour atteindre cet objet, le demandeur a observé que, à condition de se placer dans une plage de température convenable, il était possible d'utiliser des précurseurs simples constitués de chlorure de titane, de chlorure d'aluminium et d'ammoniac, à savoir les mêmes précurseurs que ceux suggérés dans l'article susmentionné mais que, dans cette plage de température, il était inutile de procéder dans un plasma.

Plus particulièrement, la présente invention prévoit un procédé de formation d'un revêtement de Ti₁₋ₓAlₓN sur une t pièce, sans recourir à une assistence plasma comprenant les étapes consistant à porter une enceinte de dépôt chimique en phase vapeur à une température comprise entre 250 et 500°C ; à placer dans cette enceinte la pièce à revêtir portée à une température de 550 à 650°C ; et à injecter dans l'enceinte un mélange de chlorures d'aluminium et de titane, de NH₃ et de H₂, la quantité molaire de NH₃ étant supérieure à la quantité molaire de chlorures et la quantité molaire d'hydrogène étant supérieure à cinq fois la quantité molaire de chlorures.

Selon un mode de réalisation de la présente invention, la pression est choisie dans une plage de 10² à 10⁵ Pa.

Selon un mode de réalisation de la présente invention, les chlorures d'aluminium et de titane sont TiCl₄ et AlCl₃.

Selon un mode de réalisation de la présente invention, les chlorures sont obtenus en injectant du chlore dans une chambre intermédiaire adjacente à l'enceinte, et contenant un alliage d'aluminium-titane porté à une température de 650 à 750°C, le débit de chlore étant choisi pour qu'il ne subsiste pas à la sortie de cette chambre intermédiaire du chlore non-combiné au titane et à l'aluminium.

La présente invention prévoit aussi un appareil de formation d'un revêtement de Ti₁₋ₓAlₓN dans une enceinte de dépôt chimique en phase vapeur, dans lequel l'enceinte comprend une chambre de réaction dans laquelle est placée la pièce à revêtir portée à une température de 550 à 650°C, une chambre auxiliaire recevant du chlore et qui contient un alliage aluminium-titane porté à une température de 650 à 750°C, et une chambre de mélange à une température de l'ordre de 250 à 550°C recevant de l'ammoniac, de l'hydrogène, et éventuellement un gaz porteur tel que de l'argon ainsi que la sortie de la chambre auxiliaire.

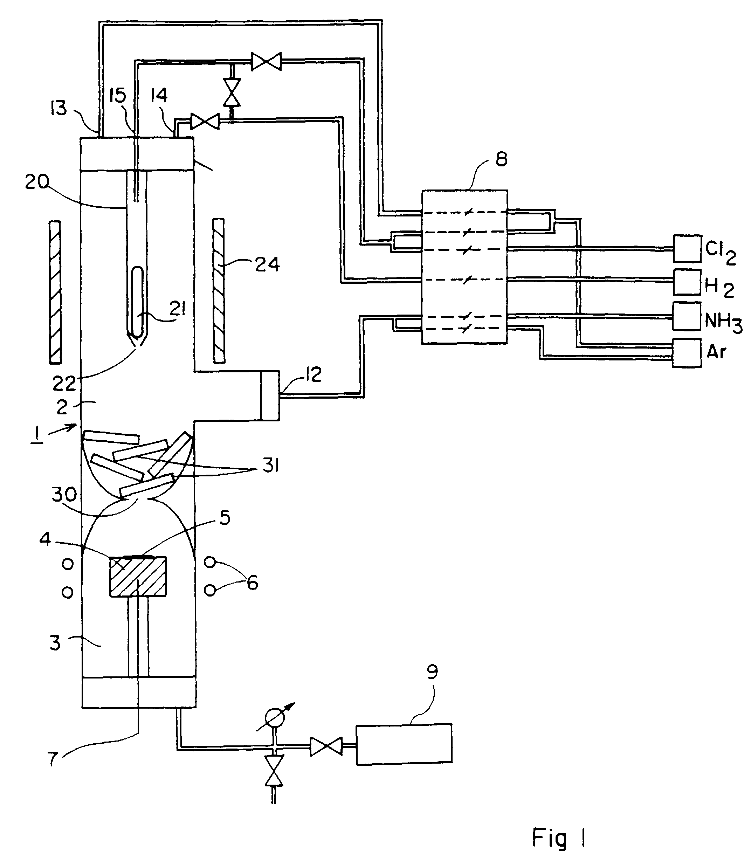

Ces objets, caractéristiques et avantages, ainsi que d'autres de la présente invention seront exposés en détail dans la description suivante d'un mode de réalisation particulier faite à titre non-limitatif en relation avec la figure 1 qui représente une installation expérimentale dans laquelle un exemple de mise en oeuvre de la présente invention a été réalisé.

La figure 1 représente une enceinte de dépôt chimique en phase vapeur 1 comprenant une chambre de mélange 2 et une chambre de réaction 3.

La chambre de réaction 3 comprend un suscepteur 4 sur lequel est placé un substrat 5 sur lequel on veut effectuer le dépôt. Le suscepteur est porté à une température de 550 à 700°C, par exemple 650°C par tout moyen approprié, par exemple par un chauffage à induction assuré par des bobines 6. La température est vérifiée par un thermocouple 7.

La chambre de mélange 2 comprend diverses entrées de gaz dont les débits peuvent être sélectivement réglés par un système de régulation 8 relié à des sources de chlore (Cl₂), d'hydrogène (H₂), d'ammoniac (NH₃) et d'argon (Ar). Ce système de régulation, associé à une pompe d'aspiration 9 reliée à la partie inférieure de la chambre de réaction, permet d'envoyer sur une première entrée 12 de la chambre 2 un mélange d'ammoniac et d'argon (l'argon étant optionnel), sur une deuxième entrée 13, éventuellement, de l'argon, et sur une troisième entrée 14 de l'hydrogène. Une quatrième entrée 15 de la chambre de mélange 2 communique avec une chambre auxiliaire 20 qui contient un alliage 21 d'aluminium et de titane AlTi. Cette quatrième entrée reçoit du chlore éventuellement additionné d'argon. Le débit de chlore est choisi pour que, à la sortie 22 de la chambre 21, on obtienne uniquement des chlorures d'aluminium et de titane à l'exclusion de chlore non-combiné. L'alliage 21 contenu dans la chambre 20 est porté à une température de l'ordre de 650 à 750°C par tout moyen de chauffage approprié, par exemple par un four à lampes 24.

Entre la sortie 22 de la chambre auxiliaire 20 et la communication 30 entre la chambre de mélange 2 et la chambre de réaction 3, les flux de gaz et l'environnement sont choisis pour que la température des gaz reste comprise entre 250 et au plus 500°C. De préférence, des obstacles 31 sont prévus au voisinage de l'ouverture 30, par exemple des barres de quartz, pour assurer un mélange efficace des divers gaz injectés dans la chambre de mélange (chlorures de titane et d'aluminium, NH₃, H₂ et éventuellement argon).

L'ammoniac est en quantité molaire nettement supérieure à la quantité molaire des chlorures sortant de la chambre auxiliaire 20. L'hydrogène est en quantité molaire au moins 5 fois supérieure, par exemple 10 fois, à la quantité molaire des chlorures.

Dans ces conditions, on a constaté un dépôt de Ti₁₋ ₓAlₓN avec x compris entre 0,1 et 0,6. Le fait qu'il s'agissait bien d'une phase unique et non pas d'un mélange de grains de TiN et d'AlN a été vérifié par des analyses par diffraction de rayons X et par microscopie électronique. Le film obtenu était, selon les conditions de dépôt, amorphe ou microcristallisé.

Bien que l'on n'ait actuellement pas d'explication certaine sur la raison pour laquelle on obtient de façon inattendue le résultat indiqué ci-dessus, on estime que ceci résulte peut-être du choix de l'alliage utilisé. En effet, la chloration a été effectuée à partir d'un alliage particulier du système AlTi, dans ce cas précis TiAl. Mais d'autres composés auraient pu être utilisés (TiAl₂, TiAl₃), séparément ou même simultanément par couple de phases voisines dans le diagramme de phases : TiAl-TiAl₂ ou TiAl₂-TiAl₃ par exemple un mélange tampon à activités fixées pour les deux éléments. L'utilisation de TiAl offre l'avantage de moduler les activités relatives de l'aluminium et du titane et donc de permettre la formation simultanée en quantités suffisantes des deux types de chlorures : les chlorures de titane et ceux d'aluminium. Dans le cas où l'on aurait utilisé une charge mixte d'Al et Ti, les calculs thermodynamiques indiquent que les chlorures les plus stables se seraient formés au détriment des autres entraînant par exemple un excès de AlCl₃, Al₂Cl₆ au dépend de TiCl₃ et TiCl₄. Avec TiAl, il sera également possible de moduler les proportions des chlorures formés en modifiant soit la pression, soit la température.

Dans le cadre d'un exemple particulier, on s'est placé dans les conditions suivantes :
durée de dépôt : 23 minutes,
température de dépôt : 600°C,
température de chambre intermédiaire : 750°C,
pression totale : 113 kPa (10 torrs),
débits (en sccm) : Cl₂ : 5,
   NH₃: 15,
   H₂: 90,
   Ar : 600,
on a alors obtenu une vitesse de dépôt de l'ordre de 50 nm par minute.

De plus, les résultats obtenus montrent que l'on peut généraliser l'invention et qu'il est possible d'obtenir des dépôts par voie chimique en phase vapeur, sans recourir à la formation d'un plasma à partir de chlorure de titane tel que TiCl₄ et de chlorure d'aluminium tel que AlCl₃ injectés dans une chambre de mélange à une température de l'ordre de 250 à 500°C en présence d'un excès d'ammoniac et d'hydrogène. L'expérience montre que la pression totale dans l'enceinte peut être librement choisie dans une plage de 10² à 10⁵ pascals. Les dépôts à pression atmosphérique présentent l'inconvénient d'une plus grande consommation de matière mais l'avantage d'une plus grande facilité de mise en oeuvre.

Bien entendu, la présente invention est susceptible de diverses variantes et modifications qui apparaîtront à l'homme de l'art. Notamment, pour effectuer des dépôts sur des pièces de formes complexes, ces pièces seront disposées directement dans la chambre de réaction et chauffées, par exemple, par induction oupar tout autre moyen adapté, par exemple dans un four à paroi chaude. Dans ce dernier cas, le dépôt se fera simultanément sur les pièces et sur les parois de la chambre de réaction.

## Revendications

1. Procédé de formation d'un revêtement de Ti₁₋ₓAlₓN sur une pièce sans recourir à une assistence plasma caractérisé en ce qu'il comprend les étapes suivantes :
porter une enceinte de dépôt chimique en phase vapeur à une température comprise entre 250 et 500°C ;
placer dans cette enceinte la pièce à revêtir portée à une température de 550 à 650°C ; et
injecter dans l'enceinte un mélange de chlorures d'aluminium et de titane, de NH₃ et de H₂, la quantité molaire de NH₃ étant supérieure à la quantité molaire de chlorures et la quantité molaire d'hydrogène étant supérieure à cinq fois la quantité molaire de chlorures.

2. Procédé selon la revendication 1, caractérisé en ce que la pression est choisie dans une plage de 10² à 10⁵ Pa.

3. Procédé selon la revendication 1, caractérisé en ce que les chlorures d'aluminium et de titane sont TiCl₄ et AlCl₃.

4. Procédé selon la revendication 1, caractérisé en ce que les chlorures sont obtenus en injectant du chlore dans une chambre intermédiaire adjacente à l'enceinte, et contenant un alliage d'aluminium-titane porté à une température de 650 à 750°C, le débit de chlore étant choisi pour qu'il ne subsiste pas à la sortie de cette chambre intermédiaire du chlore non-combiné au titane et à l'aluminium.

5. Appareil de formation d'un revêtement de Ti₁₋ₓAlₓN dans une enceinte de dépôt chimique en phase vapeur, caractérisé en ce que ladite enceinte comprend :
une chambre de réaction (3) dans laquelle est placée la pièce à revêtir portée à une température de 550 à 650°C,
une chambre auxiliaire (20) recevant du chlore et qui contient un alliage aluminium-titane porté à une température de 650 à 750°C, et
une chambre de mélange (2) à une température de l'ordre de 250 à 550°C recevant de l'ammoniac, de l'hydrogène,
et éventuellement un gaz porteur tel que de l'argon ainsi que la sortie de la chambre auxiliaire.

## Patentansprüche

1. Verfahren zum Erzeugen eines Überzugs bzw. einer Beschichtung aus Ti₁₋ₓAlₓN auf einem Werkstück, ohne Zuhilfenahme eines Plasmas,
**dadurch gekennzeichnet**, daß das Verfahren die folgenden Schritte bzw. Stufen umfaßt:
ein Behälter zur chemischen Abscheidung in der Dampfphase wird auf eine Temperatur im Bereich zwischen 250 und 500°C gebracht;
das auf eine Temperatur von 550 bis 650°C gebrachte, zu überziehende bzw. zu beschichtende Werkstück wird in diesen Behälter eingebracht;
in den Behälter wird ein Gemisch von Aluminium- und Titanchloriden, NH₃ und H₂ eingeleitet, wobei die molare Menge an NH₃ größer als die molare Menge der Chloride, und die molare Menge des Wasserstoff um das Fünffache größer als die molare Menge der Chloride ist.

2. Verfahren nach Anspruch 1, dadurch gekennzeichnet, daß der Druck in einem Bereich von 10² bis 10⁵ Pa gewählt wird.

3. Verfahren nach Anspruch 1, dadurch gekennzeichnet, daß die Aluminium- und Titanchloride TiCl₄ und AlCl₃ sind.

4. Verfahren nach Anspruchl, dadurch gekennzeichnet, daß die Chloride durch Einleiten von Chlor in eine an den Behälter angrenzende Zwischenkammer gebildet werden, welche eine auf eine Temperatur von 650 bis 750°C gebrachte Aluminium-Titan-Legierung enthält, wobei der Zufuhrdurchsatz an Chlor so gewählt wird, daß am Ausgang dieser Zwischenkammer kein nicht mit Titan und Aluminium verbundenes Chlor mehr vorliegt.

5. Apparatur zum Erzeugen eines Überzugs bzw. einer Beschichtung aus Ti₁₋ₓAlₓN in einem Behälter zur chemischen Abscheidung in der Dampfphase, **dadurch gekennzeichnet**, daß der genannte Behälter umfaßt:
eine Reaktionskammer (3), in welcher das zu überziehende bzw. zu beschichtende, auf eine Temperatur von 550 bis 650°C gebrachte Werkstück angeordnet wird,
eine Hilfskammer (20), welcher Chlor zugeführt wird und die eine auf eine Temperatur von 650 bis 750°C gebrachte Aluminium-Titan-Legierung enthält, sowie
eine Mischkammer (2) auf einer Temperatur in der Größenordnung von 250 bis 550°C, welcher Ammoniak, Wasserstoff und gegebenenfalls ein Trägergas wie beispielsweise Argon, sowie die Austrittsströmung der Hilfskammer zugeführt werden.

## Claims

1. A method of forming a coating of Ti₁₋ₓAlₓN on a part, without plasma enhancement, characterized in that it comprises the followings steps:
heating a CVD chamber at a temperature of between 250 and 500°C;
arranging in this chamber the part to be coated, at a temperature of 550 to 650°C; and
injecting in the chamber a mixture of aluminum and titanium chlorides, NH₃ and H₂, the molar quantity of NH₃ being higher than the molar quantity of the chlorides and the molar quantity of hydrogen being higher than five times the molar quantity of the chlorides.

2. The method of claim 1, characterized in that the pressure is in a range of 10² to 10⁵ Pa.

3. The method of claim 1, characterized in that the aluminum and titanium chlorides are TiCl₄ and AlCl₃.

4. The method of claim 1, characterized in that the chlorides are obtained by injecting chlorine in an intermediate chamber adjacent to said chamber, and containing an aluminum-titanium alloy at a temperature of 650-750°C, the chlorine rate being selected so that no chlorine not combined with titanium and aluminum exists at the output of this intermediate chamber.

5. An apparatus of formation of a coating of Ti₁₋ₓAlₓN in a CVD enclosure, characterized in that said enclosure comprises:
a reaction chamber (3) in which is arranged the part to be coated, at a temperature of 550-650°C;
an auxiliary chamber (20) receiving chlorine and containing an aluminum-titanium alloy at a temperature of 650-750°C; and
a mixture chamber (2) at a temperature of 250-550°C receiving ammonia, hydrogen and possibly a carrier gas such as argon and the outflow from the auxiliary chamber.
